**Europäisches Patentamt**

**European Patent Office**

**Office européen des brevets**

(19)

(11) Veröffentlichungsnummer: **0 478 055 A2**

# (12) EUROPÄISCHE PATENTANMELDUNG

(21) Anmeldenummer: **91202375.1**

(22) Anmeldetag: **17.09.91**

(51) Int. Cl.5: **H01J 37/32**, H01L 21/306

(30) Priorität: **21.09.90 DE 4029912**

(43) Veröffentlichungstag der Anmeldung:
**01.04.92 Patentblatt 92/14**

(84) Benannte Vertragsstaaten:
**DE FR GB**

(71) Anmelder: **Philips Patentverwaltung GmbH**
**Wendenstrasse 35 Postfach 10 51 49**
**W-2000 Hamburg 1(DE)**
(84) **DE**

(71) Anmelder: **N.V. Philips' Gloeilampenfabrieken**
**Groenewoudseweg 1**
**NL-5621 BA Eindhoven(NL)**
(84) **FR GB**

(72) Erfinder: **Boehnke, Ralf-Dieter**
**Schopbachweg 33e**
**W-2000 Hamburg 54(DE)**
Erfinder: **Dammann, Hans, Dr.**
**Eichenstrasse 27**
**W-2081 Tangstedt(DE)**
Erfinder: **Rabe, Gert**
**Nielandstrasse 22**
**W-2080 Pinneberg(DE)**

(74) Vertreter: **Koch, Ingo, Dr.-Ing. et al**
**Philips Patentverwaltung GmbH**
**Wendenstrasse 35 Postfach 10 51 49**
**W-2000 Hamburg 1(DE)**

(54) **Verfahren zur Bildung mindestens eines Grabens in einer Substratschicht.**

(57) Die Erfindung betrifft ein Verfahren zur Bildung eines Grabens in einer Substratschicht mittels des Jonen-Ätzverfahren. Die Solltiefe eines Grabens ist mit größerer Genauigkeit ätzbar, wenn eine Substratschicht verwendet wird, welche eine Oberschicht mit einer Ätzrate S1 und eine Unterschicht (12) mit einer abweichenden Ätzrate S2 umfaßt, daß zunächst Gräben (15) mit von der Solltiefe abweichender Anfangstiefe hergestellt werden und daß danach ohne Verwendung einer Maske der Ätzvorgang bis zum Erreichen der Solltiefe des Grabens (15) durchgeführt wird.

FIG.2

EP 0 478 055 A2

Die Erfindung bezieht sich auf ein Verfahren zur Bildung eines Grabens in einer Substratschicht mittels des Jonen-Ätzverfahrens.

Ein derartiges Verfahren ist in J. Electrochem. Soc., Solid-State Science and Technology 1983, Seiten 655 bis 659 beschrieben. Gräben müssen beispielsweise bei der Herstellung von integrierten Schaltkreisen oder für digitale optische Gitter vorgesehen werden. Die beim Ätzvorgang erreichte Tiefe muß überwacht und gemessen werden. Besonders geeignet ist dazu ein in Fig. 3 der oben genannten Druckschrift dargestelltes Laser-Interferometer.

Insbesondere bei der Herstellung der Gräben von hochwertigen digitalen optischen Phasengittern (vgl. J. Appl. Phys. 50 (6) 1979, Seiten 3841 bis 3848) muß die Solltiefe der Gräben mit einer Genauigkeit von etwa + 0,25 % geätzt werden.

Bisher wurde auf eine homogene $SiO_2$-Substratschicht eine Ätzmaske auf fotolithografischem Wege aufgebracht, welche die Substratschicht an den Stellen der einzuätzenden Gräben nicht bedeckt. Danach wurden unter Verwendung eines Ätzgases (beispielsweise $CHF_3$) die Gräben eingeätzt, wobei die erreichte Gesamttiefe der Gräben von der Oberfläche der Maskenschicht bis zur Bodenfläche der Gräben mittels eines Laser-Interferometers überwacht wurde. Man konnte dabei nicht direkt die eigentlich maßgebliche Solltiefe der in die Substratschicht eingebrachten Gräben ermitteln, sondern einen um die Restdicke der Maskenschicht erhöhten Wert. Wenn die Ätzrate des Substratmaterials und die normalerweise erheblich niedrigere Ätzrate des Maskenmaterials bekannt sind, kann man die Ätztiefe in der Substratschicht aus der Gesamttiefe des entstehenden Grabens errechnen. Leider ergibt sich dabei eine Meßungenauigkeit von mehr als etwa 5%, weil das Ätzratenverhältnis der Materialien der Maske und der Substratschicht, u.a. auch durch Verfahrensparameter bedingt, unterschiedlich sein kann.

Der Erfindung liegt die Aufgabe zugrunde, das eingangs genannte Verfahren derart zu gestalten, daß die Solltiefe eines Grabens mit größerer Genauigkeit ätzbar ist.

Die Lösung gelingt dadurch, daß eine Substratschicht verwendet wird, welche eine Oberschicht mit einer Ätzrate S1 und eine Unterschicht mit einer abweichenden Ätzrate S2 umfaßt, daß zunächst Gräben mit von der Solltiefe abweichender Anfangstiefe hergestellt werden und daß danach ohne Verwendung einer Maske der Ätzvorgang bis zum Erreichen der Solltiefe des Grabens durchgeführt wird.

Wenn die Ätzrate der Oberschicht größer als die der Unterschicht ist, muß die Anfangsgrabentiefe größer als die Solltiefe sein und umgekehrt.

Mit dem erfindungsgemäßen Verfahren ist also insbesondere mittels eines besonders geeigneten Laser-Interferometers unmittelbar die in die Substratschicht eingeätzte Grabentiefe mit hoher Genauigkeit meßbar.

Man kann die Oberschicht in Form von Grabenwandungen bildenden Streifen aufsputtern. Sauberer verlaufende Grabenwandungen erhält man jedoch dadurch, daß die Oberschicht ganzflächig auf die Unterschicht aufgesputtert wird, daß nach Aufbringung einer die Grabenflächen freilassenden Maske die Anfangstiefe der Gräben eingeätzt, daß anschließend die Maske entfernt und der Ätzvorgang bis zum Erreichen der Solltiefe des Grabens fortgesetzt wird.

Insbesondere zur Herstellung von digitalen optischen Phasengittern wird bevorzugt, daß die Unterschicht aus einem durch einen Schmelzvorgang hergestellten $SiO_2$-Festkörper und die Oberschicht aus aufgesputterten $SiO_2$ besteht. Es hat sich gezeigt, daß die nach unterschiedlichen Verfahren hergestellten $SiO_2$-Schichten zwar wesentlich (ca. 5%) unterschiedliche Ätzraten aber gleiche Brechungsindizes aufweisen, so daß das zweischichtige Substratmaterial optisch einheitlich wirkt.

Die Erfindung wird anhand der Beschreibung eines vorteilhaften Ausführungsbeispiels näher erläutert.

Fig. 1    zeigt schematisch eine Einrichtung zur Ausübung des erfindungsgemäßen Verfahrens.

Fig. 2    zeigt eine für die Erfindung geeignete Substratschicht.

Fig. 3    zeigt die Substratschichten nach Fig. 2 mit aufgebrachter Ätzmaske.

Fig. 4    zeigt die Anordnung nach Fig. 3 nach dem Einätzen der Gräben bis zu einer Anfangstiefe.

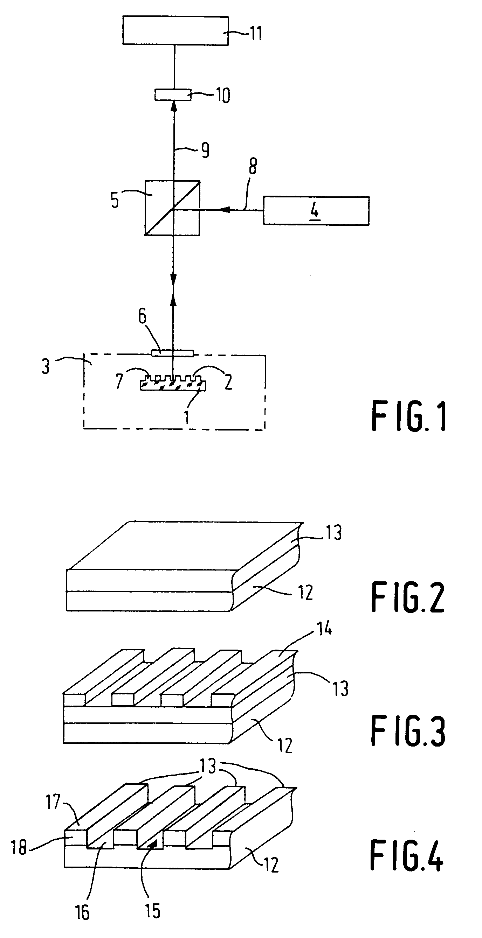

In Fig. 1 befindet sich ein digitales optisches Phasengitter 1 mit Gräben 2 in einer Jonenätzeinrichtung 3, wobei die Grabentiefe mittels eines oberhalb der Jonenätzeinrichtung 3 angedeuteten Laser-Interferometers meßbar ist. Derartige Einrichtungen sind bekannt und z.B. in der eingangs zitierten Druckschrift J. Appl.Phys. beschrieben.

Der vom Laser 4 gesendete Lichtstrahl 8 gelangt vom Strahlteiler 5 durch das Vakuum-Fenster 6 auf die Oberfläche des zu erstellenden Phasengitters 1. Von den Bodenflächen der Gräben 2 und den Oberflächen der Erhebungen reflektierte und einen Phasenunterschied aufweisende Strahlungen gelangen durch den Strahlteiler 5 als überlagerter Strahl 9 auf den Photodetektor 10, dessen Ausgangssignal periodisch in Abhängigkeit der Ätztiefe der Gräben 2 schwankt. Dabei entspricht eine Periode einer Änderung der Ätztiefe um /2, wenn die Wellenlänge des Laserlichts ist.

Mittels des Rekorders 11 wird das Ausgangssignal des Photodetektors 10 zeitabhängig aufgenommen. Derart kann die Gesamttiefe der Gräben 2 gemessen werden. Wenn die Höhe der Erhebung 7 jedoch auch Schichtdicken einer später zu entfernenden Maske umfaßt, kann die maßgebliche Ätztiefe in der Substratschicht des digitalen optischen Gitters 1 nur indirekt aus dem nur ungenau bekannten Ätzratenverhältnis der Materialien der Maske und des Substrats ermittelt werden.

Erfindungsgemäß besteht die Substratschicht gemäß Fig. 2 aus einer etwa 1 mm dicken Festkörper-Unterschicht 12 (Basis-Substrat) aus $SiO_2$, auf welche eine etwa 1,5 um dicke $SiO_2$ Oberschicht 13 aufgesputtert wurde. Für die Unterschicht und die Oberschicht 13 könnten auch andere transparente Stoffe wie z.B. $Al_2O_3$ verwendet werden. Diese Schichten könnten auch aus unterschiedlichen Stoffen bestehen. Wesentlich ist jedoch, daß die Ätzraten der für die beiden Schichten verwendeten Materialien unterschiedlich sind. Die Ätzrate des $SiO_2$-Basissubstrats betrug $S_2 = 31,7$ mm/min, die der gesputterten $SiO_2$-Oberschicht dagegen $S_1 = 33,2$ mm/min, jeweils bei gleichem vorbestimmten Druck gemessen.

Gemäß Fig. 3 wurden auf die in Fig. 2 dargestellte Substratschicht aus Photolack (Ätzrate 16,0 mm/min) bestehende Maskenstreifen (14) aufgebracht. Danach wurden mittels einer Einrichtung nach Fig. 1 zwischen den Maskenstreifen 14 Gräben 2 eingeätzt mit einer solchen Tiefe, daß die Einätztiefe in die Substratschicht nach Fig. 2 größer als die benötigte Solltiefe ist. Danach wurden die Reste der Maskenstreifen 14 entfernt, so daß ein Gebilde nach Fig. 4 entstand.

Die Kanäle 15 durchsetzen die Oberschicht 13 und dringen geringfügig in die Unterschicht 12 ein. Die erreichte Tiefe des Kanals 15 wurde optisch auf bekannte Weise mit einer Genauigkeit von etwa 1 nm ermittelt. Die gegenüber der benötigten Solltiefe größere Tiefe der Kanäle 15 wurde durch einen weiteren Ätzvorgang mittels der Einrichtung nach Fig. 1 bis zum Erreichen der Solltiefe verringert, da die Ätzraten der Bodenflächen 16 kleiner als die der Oberflächen 17 der Stege 18 sind.

**Patentansprüche**

1. Verfahren zur Bildung mindestens eines Grabens (2,15) in einer Substratschicht mittels des Jonen-Ätzverfahren, dadurch gekennzeichnet, daß eine Substratschicht verwendet wird, welche eine Oberschicht (13) mit einer Ätzrate S1 und eine Unterschicht (12) mit einer abweichenden Ätzrate S2 umfaßt, daß zunächst Gräben (15) mit von der Solltiefe abweichender Anfangstiefe hergestellt werden und daß danach ohne Verwendung einer Maske der Ätzvorgang bis zum Erreichen der Solltiefe des Grabens (15) durchgeführt wird.

2. Verfahren nach Anspruch 1, dadurch gekennzeichnet, daß die beim Ätzvorgang erreichte Tiefe des Grabens (15) mittels eines Laser-Interferometers gemessen wird.

3. Verfahren nach Anspruch 1 oder 2, dadurch gekennzeichnet, daß die Oberschicht (13) durch Kathodenzerstäubung (sputtern) auf die Unterschicht (12) aufgebracht wird.

4. Verfahren nach Anspruch 3, dadurch gekennzeichnet, daß die Oberschicht (13) in Form von Grabenwandungen bildenden Streifen aufgesputtert wird.

5. Verfahren nach Anspruch 3, dadurch gekennzeichnet, daß die Oberschicht (13) ganzflächig auf die Unterschicht (12) aufgesputtert wird, daß nach Aufbringung einer die Grabenflächen freilassenden Maske (14) die Anfangstiefe der Gräben (15) eingeätzt, daß anschließend die Maske (14) entfernt und der Ätzvorgang bis zum Erreichen der Solltiefe des Grabens (15) fortgesetzt wird.

6. Verfahren nach Anspruch 5, dadurch gekennzeichnet, daß die Ätzrate der Oberschicht (13) größer als die der Unterschicht (12) und die Anfangstiefe größer als die Solltiefe ist.

7. Verfahren nach Anspruch 6, dadurch gekennzeichnet, daß die Unterschicht (12) aus einem durch einen Schmelzvorgang hergestellten $SiO_2$-Festkörper und die Oberschicht (13) aus aufgesputterten $SiO_2$ besteht.

8. Verfahren nach einem der Ansprüche 1 bis 7, dadurch gekennzeichnet, daß zur Bildung eines digitalen optischen Phasengitters eine Vielzahl von zueinander parallelen Gräben (2,15) in die Substratschicht (Fig. 2) eingebracht wird.

FIG.1

FIG.2

FIG.3

FIG.4